(19) Europäisches Patentamt

European Patent Office

Office européen des brevets

(11) **EP 1 322 970 B1**

(12) **FASCICULE DE BREVET EUROPEEN**

(45) Date de publication et mention
de la délivrance du brevet:
**05.04.2006 Bulletin 2006/14**

(21) Numéro de dépôt: **01967401.9**

(22) Date de dépôt: **10.08.2001**

(51) Int Cl.:
*G01R 27/06* (2006.01)   *H04B 3/46* (2006.01)

(86) Numéro de dépôt international:
**PCT/FR2001/002604**

(87) Numéro de publication internationale:
**WO 2002/014882 (21.02.2002 Gazette 2002/08)**

(54) **PROCEDE ET DISPOSITIF DE MESURE DE L'ATTENUATION D'UNE LIGNE**

VERFAHREN UND VORRICHTUNG ZUR LEITUNGSDÄMPFUNGSMESSUNG

METHOD AND DEVICE FOR MEASURING A LINE ATTENUATION

(84) Etats contractants désignés:
**AT BE CH CY DE DK ES FI FR GB GR IE IT LI LU MC NL PT SE TR**

(30) Priorité: **11.08.2000 FR 0010732**

(43) Date de publication de la demande:
**02.07.2003 Bulletin 2003/27**

(73) Titulaires:
• **VIERLING COMMUNICATION SAS**
  **67116 Reichstett (FR)**
• **Vierling Communication GmbH**
  **67116 Reichstett (FR)**

(72) Inventeur: **LE HENAFF, Didier,**
**Thales Intellectual Property**
**F-94117 Arcueil Cedex (FR)**

(74) Mandataire: **Lucas, Laurent Jacques**
**Marks & Clerk France**
**31-33 Avenue Aristide Briand**
**94117 Arcueil Cédex (FR)**

(56) Documents cités:
**US-A- 5 128 619       US-A- 5 465 287**
**US-A- 5 548 222**

**Description**

La présente invention concerne un procédé selon la revendication 1 et un dispositif selon la revendication 10 de mesure de l'atténuation d'une ligne. Elle s'applique notamment à la qualification des lignes numériques à paire asymétriques (LNPA), connues sous le nom de « asymetric digital suscriber line » (ADSL) dans la littérature anglo-saxonne.

Certains opérateurs téléphoniques cherchent à développer la technologie LNPA pour offrir à leurs abonnés des débits de transmissions plus élevées sur internet. Cependant une partie des lignes téléphoniques des réseaux de ces opérateurs n'est pas assez fiable pour assurer une bonne transmission à ces débits. Ces opérateurs doivent donc déterminer quelle partie de leur réseau peut supporter ces débits de transmission. Jusqu'à présent, cette détermination est basée sur un calcul théorique de l'atténuation des lignes électriques. Ce calcul permet de déterminer l'atténuation moyenne des lignes électriques en fonction de leurs longueurs et de leurs diamètres. A partir de cette atténuation on détermine la longueur maximale théorique de la ligne pouvant supporter ces débits de transmission. Connaissant la longueur des lignes téléphoniques de son réseau, l'opérateur peut déterminer de façon théorique quelle partie du réseau supporte des débits compatibles avec la technologie LNPA. Les lignes téléphoniques ayant des défauts non modélisés, les limites théoriques sont supérieures aux limites réelles. Les opérateurs prennent donc une marge de sécurité, par exemple en se plaçant à la moitié de la limite théorique, pour être sûr que les lignes sélectionnées supportent la technologie LNPA.

Un inconvénient de cette technique est qu'une partie du réseau qui pourrait supporter les débits de transmission élevés n'est pas exploitée. Afin d'exploiter le plus grand nombre de lignes, c'est à dire d'apporter la technologie LNPA à un maximum d'abonnés, il est nécessaire de réaliser des mesures d'atténuation à 300kHz. Ces mesures d'atténuation permettent de qualifier les lignes LNPA.

Dans les techniques connues pour mesurer l'atténuation d'une ligne, on place deux techniciens aux extrémités de ladite ligne. Le premier technicien émet un signal électrique ayant une amplitude connue, le second technicien mesure le signal électrique reçu à l'autre bout de la ligne. Le rapport entre l'amplitude du signal émis et l'amplitude du signal reçu est l'atténuation de la ligne. Un inconvénient de cette technique est qu'elle est coûteuse car elle requiert deux techniciens devant se déplacer à chaque extrémité des lignes à tester.

Un but de l'invention est de pallier les inconvénients précités, et notamment de permettre de mesurer l'atténuation d'une ligne électrique à partir d'une mesure réalisée à une extrémité de la ligne seulement, et ce de manière économique.

Le document US-A-5 548 222 décrit un procédé pour mesurer l'atténuation d'une ligne à une fréquence donnée, comprenant :

(a) l'émission d'un signal électrique à une extrémité de la ligne électrique, ledit signal comprenant une composante spectrale d'amplitude $A_1$ à la fréquence F ;
(b) la mesure du signal réfléchi par l'autre extrémité de la ligne, à l'extrémité de la ligne d'où le signal a été émis ;
(c) la détermination de l'amplitude $A_2$ de la composante spectrale à la fréquence F du signal réfléchi ;
(d) la détermination de l'atténuation de la ligne à partir du rapport entre l'amplitude $A_2$ et l'amplitude $A_1$

Cependant, il faut éviter les interférences entre le signal émis et le signal réfléchi. L'invention permet de résoudre ce problème de façon simple. Selon l'invention, le signal électrique est émis pendant une durée inférieure au temps d'aller et retour d'une onde sur la ligne, afin d'éviter des interférences entre le signal émis et le signal réfléchi lors de la mesure;

D'autres caractéristiques et avantages de l'invention apparaîtront plus clairement dans la description qui va suivre et dans les figures annexées qui représentent :

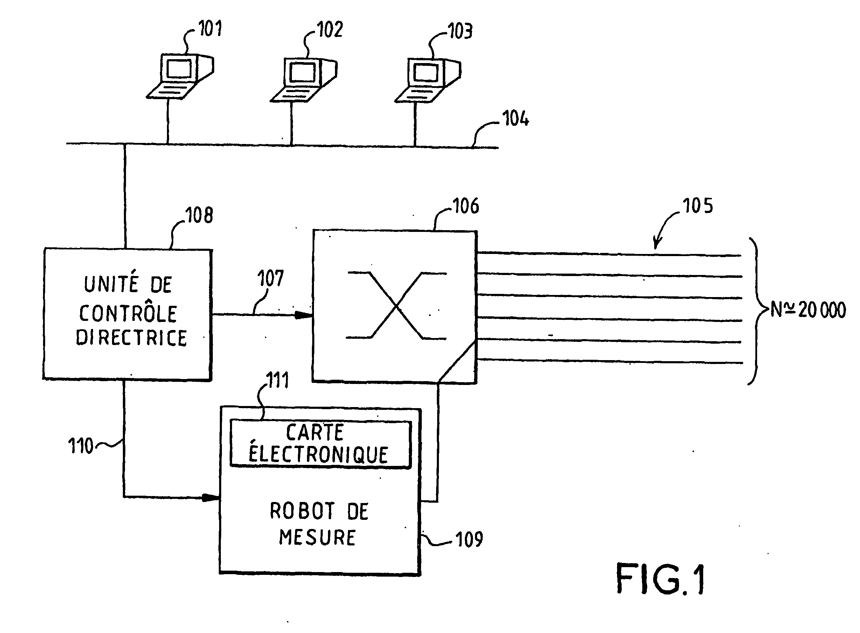

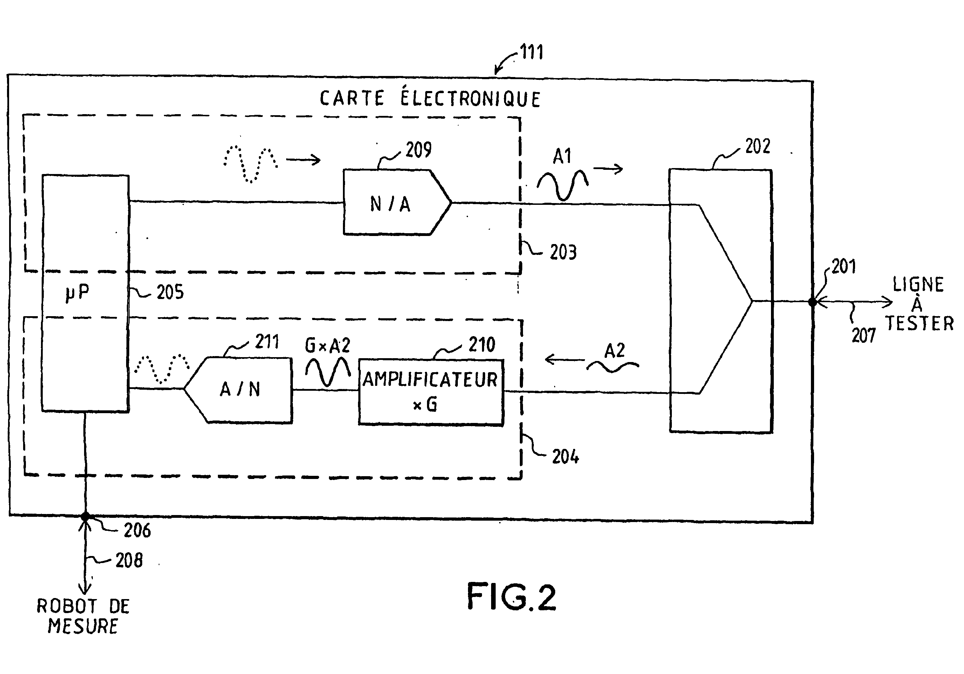

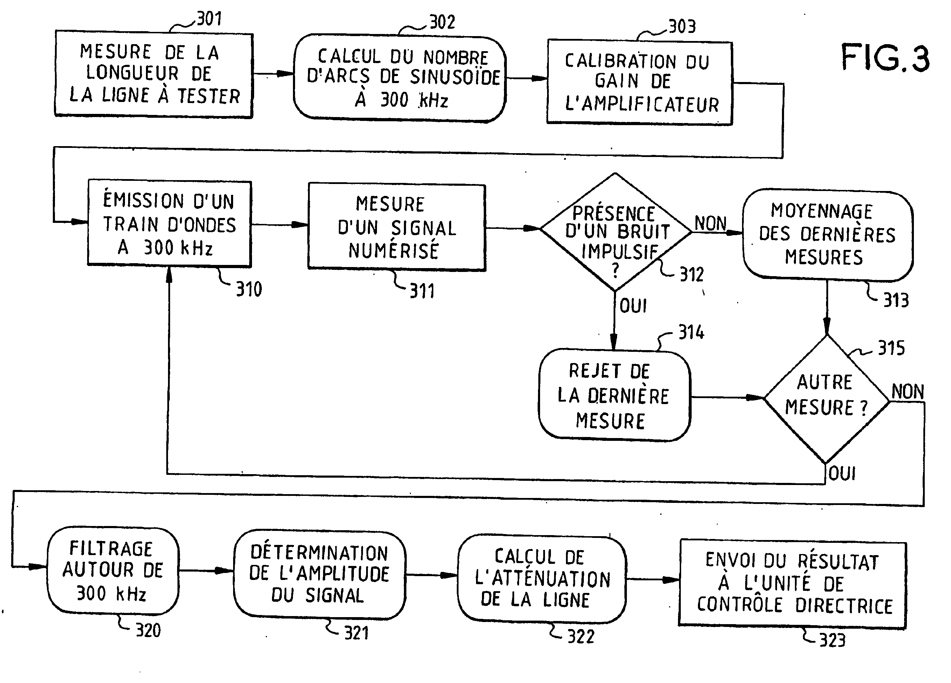

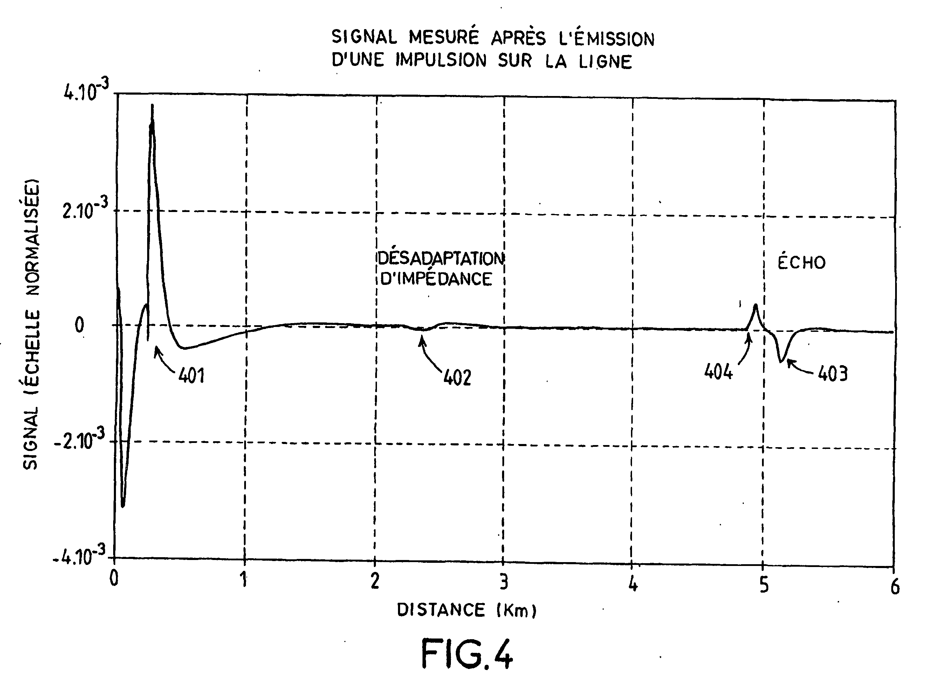

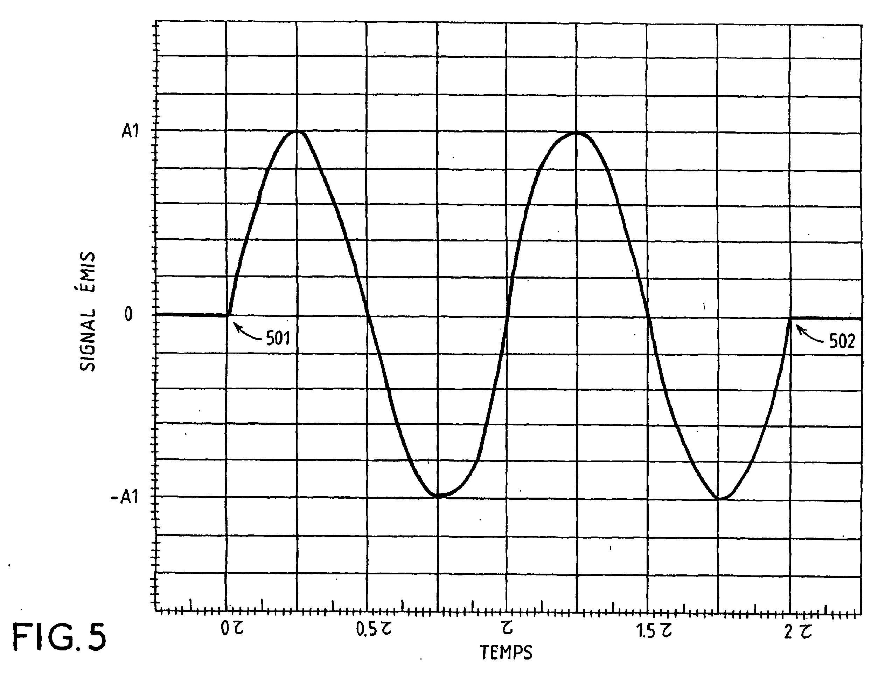

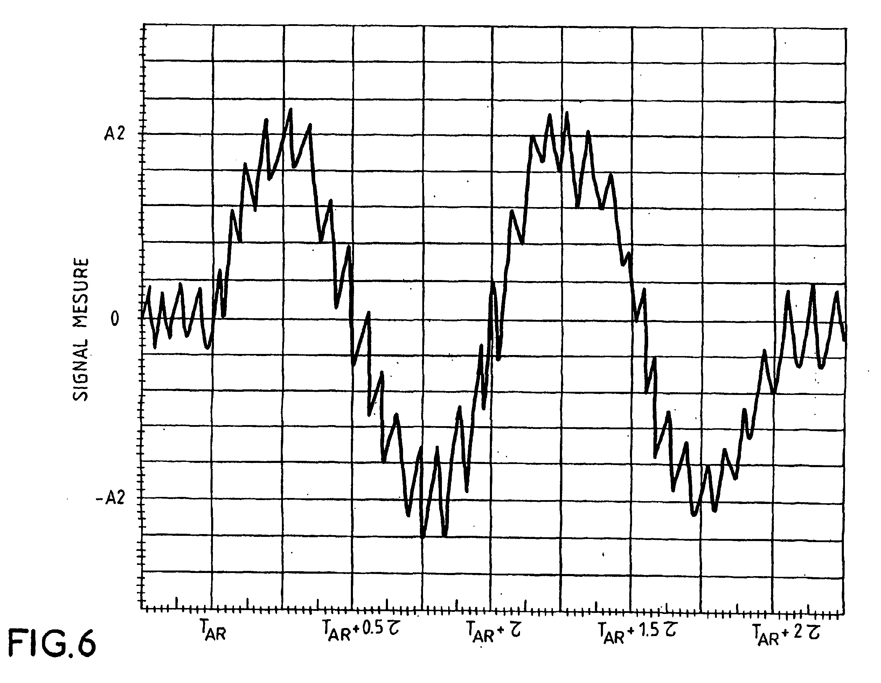

■ la figure 1, une partie d'un réseau téléphonique dont un opérateur cherche à mesurer l'atténuation des lignes en utilisant l'invention;
■ la figure 2, un exemple de réalisation d'une carte électronique représentée sur la figure 1 ;
■ la figure 3, un exemple de procédé de mesure selon l'invention ;
■ la figure 4, l'allure d'un signal mesuré après l'émission d'une impulsion sur la ligne selon l'exemple de la figure 3 ;
■ la figure 5, l'allure d'un signal sinusoïdal émis sur la ligne selon l'exemple de la figure 3 ;
■ la figure 6, l'allure d'un signal mesuré sur la ligne selon l'exemple de la figure 3.

On se réfère maintenant à la figure 1 sur laquelle est représentée une partie d'un réseau téléphonique dont un opérateur cherche à mesurer l'atténuation des lignes 105. Pour cela, l'opérateur utilise un dispositif de mesure selon l'invention. Les mesures sont effectuées de façon centralisée sur des stations de travail 101, 102, 103 connectées à un réseau interne 104 de l'opérateur. Le réseau interne 104 est utilisé par l'opérateur téléphonique pour enregistrer les temps de communications de ses abonnés. D'une façon plus générale l'opérateur téléphonique utilise le réseau interne 104 pour gérer son réseau téléphonique. Bien entendu, les abonnés de l'opérateur sont connectés au réseau téléphonique mais pas au réseau interne 104.

L'opérateur téléphonique cherche à mesurer l'atténuation des lignes 105 d'une partie de son réseau. Les lignes 105 sont reliées à un commutateur 106, lequel est contrôlé par une unité de contrôle directrice (UD) 108, encore appelée « Main Control Unit » (MCU) dans la littérature anglo-saxonne. L'unité de contrôle directrice 108 est reliée au réseau interne 104 d'une part, et au commutateur 106 par une liaison 107 d'autre part. L'unité de contrôle directrice 108 est utilisée par l'opérateur téléphonique pour établir des communications téléphoniques entre abonnés. D'une façon plus générale, l'unité de contrôle directrice 108 est utilisée pour gérer la partie de réseau téléphonique formée par les lignes 105. Les lignes 105 sont au nombre de 20 000 environ et relient des abonnés au commutateur 106.

Les mesures sur les lignes téléphoniques, telle que les mesures de tension, de courant parasite, de capacités, de résistance d'isolement, sont réalisées par des robots de mesure. D'une façon générale, les robots de mesures permettent de mesurer les propriétés conductrices des lignes téléphoniques en utilisant des courants continus ou alternatifs. Certains robots de mesures disposent de cartes échomètres qui permettent de réaliser en outre des mesures implusionnelles. Les robots de mesures sont appelés « Test and Diagnostic Unit » (TDU) dans la littérature anglo-saxonne.

L'unité de contrôle directrice 108 est reliée à un robot de mesure 109 par l'intermédiaire d'une liaison 110. Bien entendu, l'unité de contrôle directrice 108 est reliée de la même façon à plusieurs commutateurs et plusieurs robots de mesures. L'unité de contrôle directrice 108 sert d'organe de gestion des robots. Chaque commutateur est associé à un robot de mesure. Le robot de mesure 109 contient une carte électronique 111 qui permet d'effectuer des mesures d'atténuation selon l'invention.

Les techniciens de l'opérateur téléphonique commandent à distance les mesures sur les lignes. Pour cela, ils utilisent des stations de travail reliées au réseau interne 104, telles que les stations 101, 102 et 103. A partir d'une station de travail, un technicien peut sélectionner une ligne téléphonique sur laquelle il souhaite effectuer des mesures. Le numéro de la ligne sélectionnée par le technicien est transmis de la station de travail vers l'unité de contrôle directrice 108 par l'intermédiaire du réseau interne 104. Puis l'unité de contrôle directrice 108 actionne le commutateur 106 pour relier la ligne à tester sur le robot de mesure 109. L'unité de contrôle directrice 108 gère les mesures demandées par le technicien, mesures réalisées par le robot de mesure 109. Le résultat de ces mesures est alors transmis sur le réseau 104 vers la station de travail du technicien.

On se réfère maintenant à la figure 2 sur laquelle est représenté un exemple de réalisation de la carte électronique 111 représentée sur la figure 1. Cette carte électronique 111 permet de mesurer l'atténuation d'une ligne à une fréquence F choisie. Dans notre exemple, la fréquence F est de 300kHz. Une entrée 201 de la carte électronique est destinée à être reliée à une extrémité de la ligne à tester. La carte électronique comprend au moins :

(a) un aiguilleur 202, placé sur la carte électronique, relié à l'entrée 201 de la carte ;
(b) un générateur 203 de signaux sinusoïdaux à la fréquence F, placé sur la carte électronique 111 et relié au aiguilleur 202, pour envoyer un signal sinusoïdal sur la ligne, le signal sinusoïdal ayant une amplitude $A_1$ donnée ;
(c) un moyen de mesure 204 d'amplitude à la fréquence F, placé sur la carte électronique 111 et relié au aiguilleur 202, pour mesurer l'amplitude $A_2$ du signal sinusoïdal réfléchi par la ligne;
(d) un moyen de calcul 205, placé sur la carte électronique 111 et relié à une sortie 206 de la carte d'une part et au moyen de mesure 204 d'autre part, pour calculer l'atténuation de la ligne à la fréquence F à partir de l'amplitude $A_2$ mesurée et de l'amplitude $A_1$ du signal envoyé, et envoyer le résultat du calcul sur la sortie 206.

La carte électronique 111 est reliée par une liaison 207 à une extrémité de la ligne à tester. Cette liaison dans l'exemple figure 1 est la liaison entre le robot de mesure 109 et le commutateur 106. En effet, la carte électronique 111 est dans le robot de mesure 109, et le commutateur 106 est relié aux lignes à tester 105. Par conséquent, la carte électronique 111 est reliée à une extrémité de la ligne à tester.

Le moyen de calcul 205 est relié à la sortie 206, laquelle est reliée par une liaison 208 au robot de mesure 109 de la figure 1. Bien entendu, la carte électronique 111 n'est pas nécessairement incluse dans un robot de mesure. On peut citer d'autres exemples d'utilisation de cette carte électronique 111, tel que dans un appareil de mesure portatif, ou dans un ordinateur. Dans un appareil portatif, la sortie de la carte électronique 111 peut être reliée à un dispositif d'affichage par exemple.

Le aiguilleur 202 est un duplexeur dans notre exemple. Un aiguilleur ayant plus de deux sorties peut être utile si la carte électronique 111 permet d'effectuer d'autres mesures sur la ligne.

Le moyen de calcul 205 est un microprocesseur. Bien entendu, il est possible d'utiliser d'autres moyens de calcul, tel qu'un processeur de signaux numérique, connu sous le nom de « digital signal processor » (DSP) dans la littérature anglo-saxonne, des circuits électroniques spécialisés, un moyen de calcul analogique (diviseur de tension), ou tout autre moyen de calcul. Si l'atténuation est exprimée en décibels, le moyen de calcul 205 réalise l'opération suivante :

$$S = 10 \log\left(\frac{A_1}{A_2}\right) \qquad (1)$$

Dans la relation (1), S est le résultat du calcul (en décibels) réalisé par le moyen de calcul 205. Dans cette relation, le coefficient 10 correspond à 20 divisé par 2. En effet, on mesure directement l'atténuation du signal émis sur un aller-retour, c'est à dire le double (en décibels) de l'atténuation de la ligne sur un aller. Par conséquent, il faut diviser par 2 l'atténuation mesurée sur un aller et retour pour obtenir l'atténuation sur un aller.

Si l'extrémité de la ligne non reliée à la carte électronique 111, appelée terminaison, ne réfléchit par 100% du signal, il est possible de modifier la relation (1) de la manière suivante :

$$S = 10 \log\left(\frac{R \times A_1}{A_2}\right) \qquad (2)$$

Dans la relation (2), R représente le coefficient de réflexion de l'extrémité de la ligne à la fréquence F. Ce coefficient peut être mesuré une fois pour toutes si les terminaisons des lignes sont identiques. La mesure de ce coefficient R peut être faite lors d'un étalonnage de l'appareil de mesure comprenant la carte électronique. Généralement, la terminaison d'une ligne est chez un abonné, c'est à dire une prise téléphonique ou un appareil téléphonique. Lorsque l'appareil téléphonique n'est pas décroché, cette terminaison est un circuit ouvert dont le coefficient de réflexion est proche de 100%.

Le générateur 203 de signaux sinusoïdaux comprend le microprocesseur 205 et un convertisseur numérique / analogique 209. Le microprocesseur 205 échantillonne une sinusoïde numérique de fréquence F (300kHz), qui est convertie en signal analogique par le convertisseur numérique / analogique 209. Bien entendu, il est possible d'utiliser d'autres générateurs, tel qu'un oscillateur local analogique commandé en fréquence par une tension ou un signal numérique, ou un oscillateur local analogique réglé à la fréquence F, ou tout autre générateur de signaux sinusoïdaux à la fréquence F.

Le moyen de mesure d'amplitude 204 comprend le microprocesseur 205, un convertisseur analogique / numérique 211, et un amplificateur 210. L'amplificateur 210 permet d'amplifier le signal réfléchi par la ligne. Bien entendu, le coefficient d'amplification est connu. L'amplificateur 210 permet de rehausser le signal à des niveaux qui permettent une bonne numérisation. Le convertisseur analogique /numérique 211 numérise le signal amplifié. Le microprocesseur 205 calcule l'amplitude $A_2$ à partir des échantillons numérisés par le convertisseur analogique / numérique 211. Bien entendu, il est possible d'utiliser d'autres moyens de mesures d'amplitude, tel que par exemple un détecteur d'enveloppe à la fréquence F, un filtre analogique et un intégrateur, ou tout autre moyen de mesure. Ainsi, le moyen de mesure d'amplitude 204 peut délivrer un signal analogique qui sera traité de façon analogique par le moyen de calcul 205.

Le moyen de mesure d'amplitude 204 comprend le microprocesseur 205, par conséquent la liaison entre le moyen de mesure d'amplitude 204 et le moyen de calcul 205 est fonctionnelle. En effet, cette liaison est interne au microprocesseur 205. Elle permet de transmettre l'amplitude mesurée $A_2$ du moyen de mesure 204 au moyen de calcul 205.

L'invention permet à un opérateur téléphonique de tester l'atténuation des lignes à 300kHz. Cette mesure permet de déterminer quelles lignes supportent ou non les débits liés à la technologie LNPA. Les mesures permettent de qualifier des lignes qui ne l'auraient pas étés à partir d'un simple calcul théorique d'atténuation. Les mesures permettent donc d'apporter la technologie LNPA à un maximum d'abonnés.

De plus, ces mesures sont peu coûteuses par rapport aux techniques connues. En effet, les cartes électroniques selon l'invention se placent à une extrémité de la ligne à tester. En d'autres termes, il n'est pas nécessaire de faire appel à deux techniciens pour tester une ligne. De plus, si les mesures sont effectuées au niveau d'un commutateur, un seul technicien peut tester de l'ordre de 20 000 lignes.

En outre, les cartes électroniques étant installées dans des robots de mesure, les mesures d'affaiblissement peuvent être commandées à distance par un technicien. En d'autres termes, la gestion des mesures d'atténuation est centralisée. Ceci permet d'une part de définir des zones de réseaux supportant la technologie LNPA pour proposer des offres commerciales dans ces régions. D'autre part, la gestion centralisée des mesures permet de répondre en direct à un consommateur souhaitant souscrire un abonnement utilisant la technologie LNPA. Un technicien peut déterminer en quelques secondes, grâce à l'invention, si la ligne dudit consommateur supporte la technologie LNPA.

On décrit maintenant un procédé de mesure qui permet de mesurer l'atténuation d'une ligne à une fréquence F choisie. Ce procédé de mesure peut être mis en oeuvre en particulier par le robot de mesure 109 comprenant la carte électronique 111 illustré figure 1. Bien entendu, ce procédé de mesure peut aussi être mis en oeuvre par d'autres appareils de mesures, tels que des appareils portatifs ou par une combinaison d'appareils de mesures. Le procédé de mesure comprend au moins les étapes suivantes :

(a) l'émission d'un signal électrique sinusoïdal d'amplitude $A_1$, à une extrémité de la ligne électrique ;
(b) la mesure de l'amplitude $A_2$ du signal réfléchi par l'autre extrémité de la ligne, à l'extrémité de la ligne d'où le signal a été émis ;
(c) la détermination de l'atténuation de la ligne à partir de l'amplitude du signal émis $A_1$ et de l'amplitude du signal reçu $A_2$.

Le signal électrique sinusoïdal est émis pendant une durée inférieure au temps d'aller et retour d'une onde sur la ligne. Ceci permet d'éviter les interférences entre le signal émis et le signal réfléchi.

Selon un mode de mise en oeuvre avantageux, la mesure de l'amplitude $A_2$ du signal réfléchi est synchronisée avec le signal réfléchi de manière à améliorer le rapport signal à bruit.

Selon un autre mode de mise en oeuvre avantageux, le signal électrique émis comprend un nombre entier d'arcs de sinusoïde, afin d'éviter un saut d'amplitude au début ou à la fin de l'émission.

On se réfère maintenant à la figure 3 sur laquelle est illustré un exemple de procédé de mesure selon l'invention. Dans cet exemple, le procédé est mis en oeuvre par un robot de mesure tel que celui illustré à la figure 1. Bien entendu, ce procédé peut être mis en oeuvre par d'autres dispositifs.

Lors d'une première étape, on mesure 301 la longueur de la ligne à tester. Cette mesure peut être réalisée avec un échomètre placé dans le robot de mesure. La technique utilisée consiste à envoyer une impulsion électrique sur la ligne, et mesurer le temps d'aller et retour de cette impulsion. On se réfère à la figure 4 sur laquelle est représenté l'allure d'un signal mesuré après l'émission d'une impulsion sur la ligne. La vitesse de déplacement d'une onde sur la ligne étant connue à partir des caractéristiques physiques de la ligne, il est possible de convertir les temps en distance. Le rapport de conversion en temps et distance peut être de l'ordre de 11 μs/km. Par conséquent l'axe des abscisses, qui correspond au temps écoulé après l'émission de l'impulsion, est gradué en distance. L'axe des ordonnées est gradué suivant une échelle normalisée par rapport à l'amplitude de l'impulsion émise. Dans cet exemple, l'impulsion émise sur la ligne comprend un premier pic de signal, immédiatement suivi d'un second pic de signal de signe opposé et de même amplitude. La ligne réfléchit une première fois l'impulsion 401. Cette réflexion correspond à la désadaptation d'impédance en entrée de ligne. Cette désadaptation d'impédance peut venir de l'aiguilleur par exemple. Plus loin, une autre désadaptation d'impédance provoque une réflexion parasite 402. Cette désadaptation d'impédance est un défaut de la ligne. Un tel défaut peut provenir par exemple d'une mauvaise connexion dans un sous-répartiteur (SR) ou un point de concentration (PC) du réseau. L'impulsion émise est réfléchie une dernière fois 403 par la ligne. Cette réflexion est l'écho de l'extrémité de la ligne. Le début de l'écho 404 correspond à la longueur de la ligne. Dans cet exemple, la ligne mesure 4,8km. En d'autres termes, le temps écoulé entre l'émission de l'impulsion et la détection de l'écho 403 est le temps d'aller et retour sur la ligne. Ce temps est directement proportionnel à la longueur de la ligne à tester.

Après cette mesure de la longueur de la ligne 301, on connaît le temps d'aller et retour, noté $T_{AR}$, d'une impulsion sur la ligne. A partir de ce temps $T_{AR}$, on calcule 302 le nombre d'arcs de sinusoïde N vérifiant la relation suivante :

$$N = E(2 \times T_{AR} \times F) \qquad\qquad (3)$$

Dans la relation (3), E représente la fonction partie entière. Le nombre N est le nombre d'arcs d'une sinusoïde à 300kHz (valeur de la fréquence F dans cet exemple), tel que la durée de la sinusoïde soit inférieure au temps d'aller et retour $T_{AR}$, et tel que cette sinusoïde puisse commencer et terminer par zéro. En d'autres termes, N est le plus grand nombre d'arcs sinusoïde tel que la longueur totale de la sinusoïde soit inférieure au temps $T_{AR}$. On note τ la période de la sinusoïde à la fréquence F, et $T_{SIG}$ la durée de la sinusoïde à la fréquence F ayant N arcs. Ces deux grandeurs sont liées par la relation suivante :

$$T_{SIG} = \frac{1}{2} \times N \times \tau \qquad\qquad (4)$$

Bien entendu, il est possible aussi d'émettre le signal pendant une durée $T_{SIG}$ supérieure au temps d'aller et retour $T_{AR}$. Il y aura alors des interférences entre le signal émis et le signal réfléchi. Le signal réfléchi sera d'abord sans interférence pendant une durée $T_{AR}$, puis aura des interférences pendant une durée $T_{SIG}$-$T_{AR}$. La première partie du signal réfléchi pourra alors être utilisée dans les étapes suivantes de la même manière que si le signal avait été émis pendant une durée $T_{SIG}$ inférieure à $T_{AR}$.

Il est possible aussi d'émettre un signal qui n'est pas une sinusoïde pure. Ce signal peut comporter une raie à la fréquence F d'amplitude $A_1$ par exemple, ou plus généralement une composante non nulle à la fréquence F. La description suivante reste valable en remplaçant le signal sinusoïdal d'amplitude $A_1$ par un signal dont la composante spectrale à la fréquence F a une amplitude $A_1$.

Afin d'améliorer le rapport signal à bruit, on peut réaliser une calibration 303 du gain de l'amplificateur 210. Cette calibration 303 permet d'obtenir la meilleure numérisation possible du signal mesuré. Pour cela, on émet de façon itérative un signal électrique sinusoïdal de fréquence F en faisant varier à chaque itération le gain G de l'amplificateur 210. On garde le gain G le plus élevé possible qui ne fait pas saturer le convertisseur analogique / numérique 211. Afin de pouvoir utiliser le plus grand gain possible, on n'active l'amplificateur 210 que pendant la durée de retour du signal utile. De cette manière, on n'amplifie par le signal réfléchi en début de ligne (désadaptation d'impédance en entrée de ligne). Ce signal réfléchi en début de ligne saturerait le convertisseur analogique / numérique 210 avant que le signal utile ait atteint un niveau maximum. Le gain optimal G ainsi déterminé est conservé pour la suite des mesures.

On émet 310 alors un train d'ondes à 300kHz, c'est à dire un signal électrique sinusoïdal de fréquence F pendant une durée $T_{SIG}$. On se réfère à la figure 5 sur laquelle est représenté le signal sinusoïdal émis. Le signal est émis pendant N arcs de sinusoïde, où N est défini dans la relation (3). Dans cet exemple, N vaut 4. La durée d'émission du signal est $T_{SIG}$, à savoir 2 x $\tau$ dans cet exemple. En l'absence d'émission, la tension sur la ligne est nulle. L'émission débute au point 501, pris comme origine des temps sur l'axe des abscisses. L'amplitude du signal émis est $A_1$. Pendant la durée $T_{SIG}$, 4 arcs de sinusoïde sont émis. L'émission se termine au point 502. Le temps qui sépare ces deux points est exactement $T_{SIG}$. Avant le début et après la fin de l'émission, c'est à dire avant le point 501 et après le point 502, la tension sur la ligne est nulle. Le nombre d'arcs de sinusoïde étant entier, il n'y a pas de saut de tension que ce soit au début ou à la fin de l'émission. Le spectre du signal émis comprend donc un pic à la fréquence F qui n'est pas pollué par des effets de bords en début ou en fin d'émission.

Après l'émission 310 d'un train d'ondes, on attend le retour du signal réfléchi en bout de ligne. Ce signal revient à l'extrémité de la ligne d'où il a été émis après la durée $T_{AR}$. On débute alors l'enregistrement 311 du signal réfléchi. Connaissant la durée du signal émis, $T_{SIG}$, on arrête l'enregistrement lorsqu'il n'y a plus de signal. En d'autres termes, on active la mesure 311 du signal réfléchi uniquement pendant la période prévue de son retour vers l'extrémité de la ligne d'où il a été émis.

On se réfère maintenant à la figure 6 sur laquelle est représenté le signal mesuré. Ce signal est bruité et a généralement une faible amplitude. De manière à améliorer la mesure de l'amplitude du signal réfléchi, celui-ci peut être amplifié d'un facteur connu, par un amplificateur tel que l'amplificateur de la carte électronique 111 par exemple. De manière à éviter les perturbations liées au bruit, cette amplification n'est activée que pendant la période prévue du retour de la sinusoïde. C'est pourquoi on dit que la mesure de l'amplitude $A_2$ du signal réfléchi est synchronisée avec le signal réfléchi. L'amplification et l'enregistrement peuvent par exemple être synchronisés avec l'horloge d'un microprocesseur ayant permis de générer le signal.

Il existe deux bruits de nature différente sur les lignes. Un premier bruit, dit bruit stationnaire, a des propriétés statistiques constantes au cours du temps. Ce bruit stationnaire est un bruit gaussien par exemple. Un second bruit, dit bruit impulsif, apparaît de façon aléatoire dans les mesures. Ce bruit impulsif peut apparaître dans 1 mesure sur 1000 environ. Il provient notamment de perturbations radioélectriques provoquées par le passage d'un train près d'une ligne ou par une émission radio par exemple.

Afin d'améliorer le rapport signal à bruit, on peut éliminer le bruit impulsif en comparant 312 le signal mesuré avec un signal de référence. Ce signal de référence peut être par exemple la puissance moyenne d'un signal réfléchi. Si une mesure a une puissance anormale, elle est rejetée 314. En d'autres termes, on écarte les signaux trop puissants, c'est à dire ceux qui contiennent un bruit impulsif.

D'autre part, on peut améliorer le rapport signal à bruit en faisant une moyenne de plusieurs mesures. Cette moyenne permet de diminuer le bruit stationnaire, c'est à dire augmenter le rapport signal à bruit. Une mesure peut durer le l'ordre de 200μs. Par conséquent il est possible de réaliser de l'ordre de 1000 mesures en 2 à 3 secondes. On peut augmenter le rapport signal à bruit d'un facteur 30 environ avec 1000 mesures. Après chaque mesure, on effectue 313 un moyennage avec les autres mesures. Puis on teste 315 si le nombre de mesures moyennées est suffisant. S'il faut une autre mesure, on recommence à partir de l'étape 310, sinon on réalise un traitement du signal mesuré.

Lors du traitement du signal, on peut effectuer un filtrage numérique des données mesurées. Ce filtrage permet notamment de corriger les effets de distorsion engendrés par les lignes téléphoniques. Ce filtrage peut être par exemple un filtrage 320 autour de la fréquence F, à savoir 300kHz dans notre exemple. Ce filtrage 320 peut être réalisé par convolution du signal avec un filtre à réponse impulsionnelle finie (RIF). Un tel filtrage permet d'augmenter le rapport signal à bruit. On sait que le signal émis a la fréquence F, par conséquent les autres fréquences correspondent à du bruit. Ce filtrage peut être réalisé par un microprocesseur par exemple. Bien entendu, il est possible aussi de réaliser un filtrage analogique autour de la fréquence F lors de l'enregistrement des données. Ces deux filtrages, numérique d'une part, et analogique d'autre part, peuvent être réalisés successivement.

On détermine 321 ensuite à partir des données enregistrées l'amplitude $A_2$ du signal. Cette détermination peut se faire avec l'application d'une transformé de Fourier ou avec la méthode des moindres carrés par exemple.

A partir de l'amplitude A2 et de l'amplitude A1, on calcule 322 l'atténuation de la ligne en utilisant la relation (1) par exemple.

Le résultat du calcul, à savoir l'atténuation de la ligne, est alors envoyé 323 à l'unité de contrôle directrice.

La mesure 311, le moyennage 313, le filtrage 320 numérique, et la détermination 321 numérique n'est qu'un exemple pour mesurer l'amplitude $A_2$ du signal réfléchi. Il est possible de mesurer l'amplitude du signal réfléchi en utilisant d'autres techniques, telle que des techniques analogiques par exemple.

Bien entendu, l'invention ne se limite pas aux exemples décrit ci-avant. L'invention s'applique aussi bien à des réseaux de communication qu'à des réseaux de transport d'énergie. D'une façon générale, elle s'applique à tout type de ligne électrique dont on cherche à mesurer l'atténuation à une fréquence F.

**Revendications**

1. Procédé de mesure pour mesurer l'atténuation d'une ligne à une fréquence F donnée et comprenant au moins les étapes suivantes :

   (a) l'émission (310) d'un signal électrique à une extrémité de la ligne électrique, ledit signal comprenant une composante spectrale d'amplitude $A_1$ à la fréquence F ;
   (b) la mesure (311) du signal réfléchi par l'autre extrémité de la ligne, à l'extrémité de la ligne d'où le signal a été émis ;
   (c) la détermination (321) de l'amplitude $A_2$ de la composante spectrale à la fréquence F du signal réfléchi ;
   (d) la détermination (322) de l'atténuation de la ligne à partir du rapport entre l'amplitude $A_2$ et l'amplitude $A_1$, **caractérisé en ce que** le signal électrique est émis pendant une durée inférieure au temps d'aller et retour d'une onde sur la ligne, afin d'éviter des interférences entre le signal émis et le signal réfléchi lors de la mesure.

2. Procédé de mesure selon la revendication 1 **caractérisé en ce que** la mesure du signal réfléchi est synchronisée avec le signal réfléchi, afin d'améliorer le rapport signal à bruit.

3. Procédé de mesure selon l'une des revendications précédentes **caractérisé en ce que** le bruit stationnaire est atténué en répétant les étapes d'émission et de mesure, puis en effectuant une moyenne desdites mesures.

4. Procédé de mesure selon l'une des revendications précédentes **caractérisé en ce que** le bruit impulsif est éliminé en rejetant les mesures ayant puissance anormalement élevée par rapport à un signal de référence.

5. Procédé de mesure selon l'une des revendications précédentes **caractérisé en ce que** le signal électrique émis a une forme sinusoïdale.

6. Procédé de mesure selon la revendication 5 **caractérisé en ce que** le signal électrique émis comprend un nombre entier d'arcs de sinusoïde, afin d'éviter un saut d'amplitude au début ou à la fin de l'émission.

7. Procédé de mesure selon l'une des revendications précédentes **caractérisé en ce qu'**il comprend une étape de filtrage par un filtre passe bande, centré autour de la fréquence F.

8. Procédé de mesure selon l'une des revendications précédentes **caractérisé en ce que** l'amplitude $A_2$ est déterminée à partir de mesures d'amplitudes échantillonnées du signal réfléchi sur lesquelles est réalisée une régression linéaire.

9. Procédé de mesure selon l'une des revendications 1 à 7 **caractérisé en ce que** l'amplitude $A_2$ est déterminée à

partir de mesures d'amplitudes échantillonnées du signal réfléchi sur lesquelles est réalisée une transformé de Fourier.

10. Dispositif de mesure qui permet de mesurer l'atténuation d'une ligne à une fréquence F choisie et comprend au moins :

(a) un moyen d'émission (203) d'un signal électrique destiné à être relié (207) à une extrémité de la ligne, ledit signal comprenant une composante spectrale d'amplitude $A_1$ à la fréquence F ;
(b) un moyen de mesure (204) de l'amplitude $A_2$ de la composante spectrale à la fréquence F du signal réfléchi par l'autre extrémité de la ligne, destiné à être relié à l'extrémité de la ligne d'où le signal a été émis ;
(c) un moyen de calcul (205) pour déterminer l'atténuation de la ligne à partir du rapport entre l'amplitude $A_2$ et l'amplitude $A_1$ ; et **caractérisé par**
(d) un moyen de mesure du temps d'aller et retour d'une onde sur la ligne, ce moyen de mesure étant relié fonctionnellement au moyen d'émission, afin d'émettre le signal électrique sinusoïdal pendant une durée inférieure audit temps d'aller et retour.

11. Dispositif de mesure selon l'une des revendications 10 **caractérisé en ce qu'**il comprend un moyen de synchronisation pour mesurer l'amplitude A2 pendant la période prévue du retour du signal.

12. Dispositif de mesure selon l'une des revendications 10 à 11 **caractérisé en ce qu'**il comprend un filtre passe bande analogique, centré autour de la fréquence F, pour éliminer des bruits avant la mesure de l'amplitude $A_2$.

13. Dispositif de mesure selon l'une des revendications 10 à 12 **caractérisé en ce que** le moyen de calcul réalise un filtrage numérique, centré autour de la fréquence F, pour éliminer des bruits de mesure lors de la mesure de l'amplitude $A_2$.

14. Dispositif de mesure selon l'une des revendications 10 à 13 **caractérisé en ce que** le moyen de calcul agit sur le moyen de mesure pour moyenner plusieurs signaux.

15. Carte électronique (111) pour dispositif de mesure selon la revendication 10, **caractérisée en ce qu'**elle permet de mesurer l'atténuation d'une ligne à une fréquence F choisie, une entrée de la carte électronique étant destinée à être reliée à une extrémité de ladite ligne, la carte électronique comprenant au moins :

(a) un aiguilleur (202), placé sur la carte électronique, relié à l'entrée de la carte ;
(b) un générateur (203) de signaux sinusoïdaux à la fréquence F, placé sur la carte électronique et relié à l'aiguilleur, pour envoyer un signal sinusoïdal sur la ligne, le signal sinusoïdal ayant une amplitude $A_1$ donnée, et une durée inférieure au temps d'aller et retour d'une onde sur la ligne ;
(c) le moyen de mesure (204) d'amplitude à la fréquence F, placé sur la carte électronique et relié au aiguilleur, pour mesurer l'amplitude $A_2$ du signal sinusoïdat réfléchi par la ligne;
(d) le moyen de calcul (205), placé sur la carte électronique et relié fonctionnellement à une sortie de la carte d'une part et au moyen de mesure d'autre part, pour calculer l'atténuation de la ligne à la fréquence F à partir de l'amplitude $A_2$ mesurée et de l'amplitude $A_1$ du signal envoyé, et envoyer le résultat du calcul sur la sortie.

16. Robot de mesure, **caractérisé en ce qu'**il comprend une carte électronique selon la revendication 15.

**Patentansprüche**

1. Verfahren zur Messung der Dämpfung einer Leitung auf eine vorgegebene Frequenz F, das mindestens die folgenden Schritte umfasst:

(a) die Aussendung (310) eines elektrischen Signals am Ende einer elektrischen Leitung; das ausgesendete Signal enthält eine Spektralkomponente der Amplitude $A_1$ zur Frequenz F;
(b) die Messung (311) des durch das andere Leitungnende reflektierten Signals an dem Ende der Leitung, an dem das Signal ausgesendet wurde;
(c) die Bestimmung (321) der Amplitude $A_2$ der Spektralkomponente zur Frequenz F des reflektierten Signals;
(d) die Bestimmung (322) der Leitungndämpfung nach dem Verhältnis Amplitude $A_2$/Amplitude $A_1$, **dadurch gekennzeichnet, dass** die Dauer des ausgesendeten elektrischen Signals kürzer ist als die Zeit, die eine Welle benötigt, um auf der Leitung hin und her zu laufen, **dadurch** werden Interferenzen zwischen dem ausgesendeten Signal und dem reflektierten Signal während der Messung vermieden.

2. Verfahren zur Messung nach Patenanspruch 1, **dadurch gekennzeichnet, dass** die Messung des reflektierten Signals mit dem reflektierten Signal synchronisiert ist, um das Verhältnis Signal/Geräusch zu verbessern.

3. Verfahren zur Messung nach einem der vorangehenden Patentansprüche, **dadurch gekennzeichnet, dass** das stationäre Geräusch abgeschwächt wird bei Wiederholung der Schritte von Aussendung und Messung, und dann ein Mittelwert errechnet wird aus den genannten Messungen.

4. Verfahren zur Messung nach einem der vorangehenden Patentansprüche, **dadurch gekennzeichnet, dass** das Impulsgeräusch unterdrückt wird, indem Messungen mit einer im Verhältnis zum Referenzsignal anormal hohen Leistung für ungültig erklärt werden.

5. Verfahren zur Messung nach einem der vorangehenden Patentansprüche, **dadurch gekennzeichnet, dass** das ausgesendete elektrische Signal sinusförmig ist.

6. Verfahren zur Messung nach Patentanspruch 5, **dadurch gekennzeichnet, dass** das ausgesendete elektrische Signal eine Ganzzahl von Sinuskurven umfasst, um einen Amplitudensprung am Anfang oder am Ende der Aussendung zu vermeiden.

7. Verfahren zur Messung nach einem der vorangehenden Patentansprüche, **dadurch gekennzeichnet, dass** es einen Schritt zur Filterung durch einen Bandpassfilter beinhaltet, der um die Frequenz F zentriert ist.

8. Verfahren zur Messung nach einem der vorangehenden Patentansprüche, **dadurch gekennzeichnet, dass** die Amplitude $A_2$ bestimmt wird durch Stichprobenmessungen der Amplitude des reflektierten Signals, auf deren Grundlage eine lineare Regression vorgenommen wird.

9. Verfahren zur Messung nach einem der Patentansprüche 1 bis 7, **dadurch gekennzeichnet, dass** die Amplitude $A_2$ bestimmt wird durch Stichprobenmessungen der Amplitude des reflektierten Signals, auf deren Grundlage eine Fourier-Umwandlung vorgenommen wird.

10. Messvorrichtung zur Dämpfung der Leitung auf eine ausgewählte Frequenz F, die mindestens umfasst:

(a) ein Mittel zur Aussendung (203) eines elektrischen Signals, das mit einem Ende der Leitung verbunden ist (207); das ausgesendete Signal enthält eine Spektralkomponente der Amplitude $A_1$ zur Frequenz F;
(b) ein Mittel zur Messung (204) der Amplitude $A_2$ der Spektralkomponente zur Frequenz F des durch das andere Ende der Leitung reflektierten Signals, das mit dem Ende der Leitung verbunden ist, von dem das Signal ausgesendet wurde;
(c) ein Mittel zur Berechnung (205) für die Bestimmung der Leitungndämpfung nach dem Verhältnis Amplitude $A_2$/Amplitude $A_1$;
(d) ein Mittel zur Messung der Zeit, die eine Welle benötigt, um auf der Leitung hin und her zu laufen; **dadurch gekennzeichnet, dass** dieses Messmittel funktionell verbunden ist mit dem Mittel zur Aussendung, um das sinusförmige elektrische Signal während einer Dauer auszusenden, die kürzer ist als die Zeit des Hin- und Herlaufens.

11. Messvorrichtung nach einem der Patentansprüche 10, **dadurch gekennzeichnet, dass** sie ein Mittel zur Synchronisation umfasst für die Messung der Amplitude $A_2$ während der für die Rückkehr des Signals vorgesehenen Zeit.

12. Messvorrichtung nach einem der Patentansprüche 10 bis 11, **dadurch gekennzeichnet, dass** sie einen analogen Bandpassfilter beinhaltet, der um die Frequenz F zentriert ist, um die Geräusche vor der Messung der Amplitude $A_2$ zu unterdrücken.

13. Messvorrichtung nach einem der Patentansprüche 10 bis 12, **dadurch gekennzeichnet, dass** das Mittel zur Berechnung eine digitale Filterung ausführt, die um die Frequenz F zentriert ist, um Messgeräusche während der Messung der Amplitude $A_2$ zu unterdrücken.

14. Messvorrichtung nach einem der Patentansprüche 10 bis 13, **dadurch gekennzeichnet, dass** das Mittel zur Berechnung auf das Mittel zur Messung wirkt, um den Mittelwert mehrerer Signale zu ermitteln.

**15.** Leiterplatte (111) für die Messvorrichtung nach Patentanspruch 10, **dadurch gekennzeichnet, dass** sie die Messung der Leitungndämpfung auf eine gewählte Frequenz F ermöglicht; ein Eingang der Leiterplatte ist mit einem Ende der besagten Leitung verbunden. Die Leiterplatte umfasst mindestens:

(a) einen Umschalter (202) auf der Leiterplatte, verbunden mit dem Eingang der Platte;
(b) ein Generator (203) für sinusförmige Signale zur Frequenz F, der auf der Leiterplatte installiert ist und mit dem Umschalter verbunden ist, um ein sinusförmiges Signal auf die Leitung auszusenden, wobei das sinusförmige Signal eine vorgegebene Amplitude $A_1$ hat und eine Dauer, die kürzer ist als die Zeit, die eine Welle benötigt, um auf der Leitung hin und her zu laufen;
(c) das Mittel zur Messung (204) der Amplitude zur Frequenz F, das auf der Leiterplatte installiert ist, und mit dem Umschalter verbunden ist, um die Amplitude $A_2$ des durch die Leitung reflektierten sinusförmigen Signals zu messen;
(d) das Mittel zur Berechnung (205), das auf der Leiterplatte installiert ist, und funktionell einerseits verbunden ist mit einem Ausgang der Platte, andererseits mit dem Mittel zur Messung, um die Dämpfung der Leitung auf die Frequenz F zu berechnen, ausgehend von der gemessenen Amplitude $A_2$ und der Amplitude $A_1$ des ausgesendeten Signals, und um das Ergebnis der Berechnung an den Ausgang zu senden.

**16.** Messroboter, **dadurch gekennzeichnet, dass** er eine Leiterplatte nach Patentanspruch 15 umfasst.


**Claims**

**1.** Measurement process for measuring the attenuation of a line at a given frequency F and comprising at least the following steps:

(a) the emission (310) of an electric signal at one end of the electric line, said signal comprising a spectral component of amplitude $A_1$ at the frequency F;
(b) the measurement (311) of the signal reflected by the other end of the line, at the end of the line from where the signal was emitted;
(c) the determination (321) of the amplitude $A_2$ of the spectral component at the frequency F of the reflected signal;
(d) the determination (322) of the attenuation of the line from the ratio of the amplitude $A_2$ to the amplitude $A_1$, **characterized in that** the electric signal is emitted for a duration less than the outward and return time of a wave on the line, so as to preclude interference between the signal emitted and the signal reflected during the measurement.

**2.** Measurement process according to Claim 1, **characterized in that** the measurement of the reflected signal is synchronized with the reflected signal, so as to improve the signal-to-noise ratio.

**3.** Measurement process according to either of the preceding claims, **characterized in that** the stationary noise is attenuated by repeating the emission and measurement steps, then by averaging said measurements.

**4.** Measurement process according to one of the preceding claims, **characterized in that** the impulsive noise is eliminated by rejecting the measurements having abnormally high power relative to a reference signal.

**5.** Measurement process according to one of the preceding claims, **characterized in that** the electric signal emitted has a sinusoidal form.

**6.** Measurement process according to Claim 5, **characterized in that** the electric signal emitted comprises an integer number of arcs of a sinusoid, so as to preclude an amplitude jump at the beginning or at the end of the emission.

**7.** Measurement process according to one of the preceding claims, **characterized in that** it comprises a step of filtering by a bandpass filter, centred around the frequency F.

**8.** Measurement process according to one of the preceding claims, **characterized in that** the amplitude $A_2$ is determined from measurements of the reflected signal's sampled amplitudes on which a linear regression is carried out.

9. Measurement process according to one of Claims 1 to 7, **characterized in that** the amplitude $A_2$ is determined from measurements of the reflected signal's sampled amplitudes on which a Fourier transform is carried out.

10. Measurement device which makes it possible to measure the attenuation of a line at a chosen frequency F and comprises at least:

(a) a means of emission (203) of an electric signal intended to be linked (204) to one end of the line, said signal comprising a spectral component of amplitude $A_1$ at the frequency F;

(b) a means of measuring (204) the amplitude $A_2$ of the spectral component at the frequency F of the signal reflected at the other end of the line, intended to be linked to the end of the line from where the signal was emitted;

(c) a means of calculation (205) for determining the attenuation of the line from the ratio of the amplitude $A_2$ to the amplitude $A_1$, and is **characterized by**:

(d) a means of measuring the outward and return time of a wave on the line, this means of measurement being functionally linked to the means of emission, so as to emit the sinusoidal electric signal for a duration less than said outward and return time.

11. Measurement device according to Claim 10, **characterized in that** it comprises a means of synchronization for measuring the amplitude $A_2$ for the scheduled period of the return of the signal.

12. Measurement device according to either of Claims 10 and 11, **characterized in that** it comprises an analogue bandpass filter, centred around the frequency F, so as to eliminate noises before the measurement of the amplitude $A_2$.

13. Measurement device according to one of Claims 10 to 12, **characterized in that** the means of calculation carries out a digital filtering, centred around the frequency F, so as to eliminate measurement noises during the measurement of the amplitude $A_2$.

14. Measurement device according to one of Claims 10 to 13, **characterized in that** the means of calculation acts on the means of measurement so as to average several signals.

15. Electronic card (111) for measurement device according to Claim 10, **characterized in that** it makes it possible to measure the attenuation of a line at a chosen frequency F, an input of the electronic card being intended to be linked to one end of said line, the electronic card comprising at least:

(a) a dispatcher (202), placed on the electronic card, linked to the input of the card;

(b) a generator (203) of sinusoidal signals at the frequency F, placed on the electronic card and linked to the dispatcher, so as to send a sinusoidal signal over the line, the sinusoidal signal having a given amplitude $A_1$, and a duration less than the outward and return time of a wave on the line;

(c) the means of measurement (204) of amplitude at the frequency F, placed on the electronic card and linked to the dispatcher, so as to measure the amplitude $A_2$ of the sinusoidal signal reflected by the line;

(d) the means of calculation (205), placed on the electronic card and linked functionally to an output of the card on the one hand and to the means of measurement on the other hand, so as to calculate the attenuation of the line at the frequency F from the measured amplitude $A_2$ and from the amplitude $A_1$ of the signal sent, and to send the result of the calculation to the output.

16. Measurement robot, **characterized in that** it comprises an electronic card according to Claim 15

FIG.1

101 102 103

104

108

UNITÉ DE
CONTRÔLE
DIRECTRICE

107

106

105

N ≈ 20 000

110

111

CARTE
ÉLECTRONIQUE

ROBOT DE
MESURE

109

EP 1 322 970 B1

FIG.2

FIG.3

```
┌─────────────────┐     ┌─────────────────┐     ┌─────────────────┐
│  MESURE DE LA   │     │ CALCUL DU NOMBRE│     │  CALIBRATION DU │
│   LONGUEUR DE   │────▶│ D'ARCS DE SINUSOÏDE│──▶│     GAIN DE     │
│ LA LIGNE À TESTER│     │    À 300 kHz    │     │ L'AMPLIFICATEUR │
└─────────────────┘     └─────────────────┘     └─────────────────┘
       301                    302                    303
```

```
┌─────────────────┐     ┌─────────────────┐      ◇ PRÉSENCE ◇      ┌─────────────────┐
│  ÉMISSION D'UN  │     │     MESURE      │     ╱ D'UN BRUIT ╲ NON │   MOYENNAGE     │
│  TRAIN D'ONDES  │────▶│  D'UN SIGNAL    │────▶│   IMPULSIF    ├────▶│  DES DERNIÈRES  │
│    À 300 kHz    │     │    NUMÉRISÉ     │     ╲      ?      ╱     │    MESURES      │
└─────────────────┘     └─────────────────┘      ◇───────◇         └─────────────────┘
       310                    311                 │   312                    313
                                                  │ OUI
                                                  ▼
                                         ┌─────────────────┐      ◇ AUTRE ◇
                                         │    REJET DE     │     ╱         ╲ NON
                                         │  LA DERNIÈRE    │────▶│  MESURE ? │
                                         │     MESURE      │     ╲         ╱
                                         └─────────────────┘      ◇───────◇  315
                                               314                 │ OUI
```

```
┌─────────────────┐     ┌─────────────────┐     ┌─────────────────┐     ┌─────────────────┐
│    FILTRAGE     │     │  DÉTERMINATION  │     │   CALCUL DE     │     │ ENVOI DU RÉSULTAT│
│   AUTOUR DE     │────▶│  DE L'AMPLITUDE │────▶│ L'ATTÉNUATION   │────▶│   À L'UNITÉ DE  │
│    300 kHz      │     │    DU SIGNAL    │     │  DE LA LIGNE    │     │CONTRÔLE DIRECTRICE│
└─────────────────┘     └─────────────────┘     └─────────────────┘     └─────────────────┘
       320                    321                    322                    323
```

EP 1 322 970 B1

14

SIGNAL MESURÉ APRÈS L'ÉMISSION
D'UNE IMPULSION SUR LA LIGNE

FIG.4

FIG.5

EP 1 322 970 B1

FIG.6